# EUROPÄISCHE PATENTSCHRIFT

(11) **EP 2 523 918 B1**
(45) Veröffentlichungstag und Bekanntmachung des Hinweises auf die Patenterteilung: **28.08.2019**
(21) Anmeldenummer: 11717536.4
(22) Anmeldetag: 20.04.2011
(51) Int. Cl.: C03C 3/17, C03C 27/00, C03C 10/02, C03C 17/02, C03C 17/22, C09J 1/00, H01L 33/48, G02B 1/10, G02B 19/00, H01L 33/50, H01L 33/58

(54) **OPTOELEKTRONISCHES HALBLEITERBAUELEMENT ENTHALTEND ALKALIFREIES UND HALOGENFREIES METALLPHOSPHAT**
OPTOELECTRONIC SEMICONDUCTOR PART CONTAINING ALKALI-FREE AND HALOGEN-FREE METAL PHOSPHATE
COMPOSANT SEMI-CONDUCTEUR OPTOÉLECTRONIQUE CONTENANT UN PHOSPHATE MÉTALLIQUE EXEMPT D'ALCALINS ET EXEMPT D'HALOGÈNES

(30) Priorität: 07.05.2010 DE 102010028776
(43) Veröffentlichungstag der Anmeldung: 21.11.2012
(73) Patentinhaber: OSRAM GmbH, 80807 München (DE)
(72) Erfinder: EBERHARDT, Angela, 86157 Augsburg (DE); WILLE, Christina, 86316 Friedberg (DE); WIRTH-SCHÖN, Joachim, 89312 Günzburg (DE)
(86) Internationale Anmeldenummer: PCT/EP2011/056292
(87) Internationale Veröffentlichungsnummer: WO 2011/138169

(56) Entgegenhaltungen:
- EP-A1- 2 436 659
- WO-A1-2011/013776
- US-A- 2 538 867
- US-A- 3 870 737
- US-A- 3 885 974
- US-A- 4 771 020
- US-A1- 2004 207 314
- US-A1- 2006 057 407
- US-A1- 2009 166 651
- US-A1- 2010 095 705
- US-B1- 6 461 415
- DATABASE WPI Week 200816 Thomson Scientific, London, GB; AN 2008-C14222 XP002655130, -& JP 2008 034546 A (NICHIA KAGAKU KOGYO KK) 14. Februar 2008 (2008-02-14)
- YU-FENG LIU ET AL.: "Preparation and its luminescent properties of AlPO4:Eu3+ phosphor for w-LED applications", JOURNAL OF ALLOYS AND COMPOUNDS, Bd. 509, Nr. 21, 16. März 2011 (2011-03-16), Seiten L199-L202, XP008139949, DOI: 10.1016/j.jallcom.2011.03.064

## Beschreibung

### Technisches Gebiet

Die Erfindung geht aus von einem optoelektronischen Halbleiterbauelement gemäß dem Oberbegriff des Anspruchs 1.

### Stand der Technik

Die DE-A 10 11 8630 und DE-A 10 15 9544 offenbaren LEDs mit Glasbauteilen. Die US-A 5965469 offenbart ein Phosphatglas, das als Kleber verwendet wird. Die US 2006057407 A1 und die darin zitierte US6461415 B1 offenbaren Aluminiumphosphat Beschichtungsmaterialien, Kleber und Bauteile für LEDs. Insbesondere beschreibt die US 2006057407 A1 ein Präkursor-basiertes Verfahren zum Beschichten von Oberflächen mit Aluminiumphosphat (Metallphosphat) und zählt unter anderem mögliche Anwendungsbereiche in Verbindung mit Halbleiterbauelementen auf, wie Beschichten von Polymeren, z.B. Beschichten von LED-Gehäusen oder Beschichten von Substraten für elektronische oder optoelektronische Bauelemente, und Verkleben zweier ähnlicher verschiedener optischer Materialien. Ferner beschreibt die US6461415 B1 einen amorphen Aluminiumphosphat-basierten Werkstoff, dessen Temperaturstabilität durch einen Überschuss an Aluminium erhöht wird. Die JP2008034546 A lehrt eine Schutzschicht bestehend aus Aluminiumphosphatglas für ein LED-Gehäusebauteil, deren Zusammensetzung eine Verarbeitung bei niedrigen Temperaturen ermöglicht.

### Darstellung der Erfindung

Eine Aufgabe der vorliegenden Erfindung ist es, bei einem optoelektronischen Halbleiterbauelement mit einem Konversionselement mit Leuchtstoff wie beispielsweise einer LED gemäß dem Oberbegriff des Anspruchs 1 eine besonders temperatur- und witterungsbeständige Verklebung oder Komponenten für das Konversionselement bzw. den Leuchtstoff anzugeben.

Diese Aufgabe wird gelöst durch die kennzeichnenden Merkmale des Anspruchs 1.

Besonders vorteilhafte Ausgestaltungen finden sich in den abhängigen Ansprüchen.

Die vorliegende Erfindung löst das Problem eine Verklebung oder Komponenten für das Konversionselement bzw. den Leuchtstoff bei LED anzugeben, die temperatur- und witterungsbeständig sind. Derartige Bauteile erhöhen die Effizienz und auch die Lebensdauer von LEDs.

Bisher werden LEDs meist unter Einbeziehung organischer Komponenten hergestellt, insbesondere gilt das für das Board, die Linse oder auch für Konversionselemente der LED. Überdies wird oft bei Klebungen ein organischer Kleber verwendet, beispielsweise um einen Deckel aus Glas anzubringen oder ein Konversionselement auf einen Chip aufzukleben.

Derartige organische Komponenten haben typisch eine schlechte Wärmeleitfähigkeit und eine geringe UV-Beständigkeit, insbesondere was die Resistenz gegen Strahlung im Bereich unter 420 nm betrifft. Außerdem sind sie temperaturempfindlich. Letztlich führt dies alles zu einer geringen Effizienz, weil sich die LED verfärbt oder bei zu hoher Temperatur betrieben wird.

Erfindungsgemäß wird für Verklebungen ein Metallphosphat verwendet, bzw. es werden Komponenten aus Metallphosphat verwendet. Dadurch wird eine verbesserte Wärmeleitfähigkeit und eine bessere UV-Beständigkeit erreicht. Das Metallphosphat ist vorzugsweise bleifrei oder bleiarm mit einem Anteil unter 1 Mol.-%.

Dem Metallphosphat können Zusatzstoffe und/oder strahlungsabsorbierende Elemente und/oder den Brechungsindex verändernde Komponenten zugesetzt sein. Diese Komponenten sind vorzugsweise anorganisch. Bei dem Metallphosphat kann es sich beispielsweise um Aluminiumphosphat, Yttriumphosphat, Erdalkaliphosphat, Phosphate der III. Hauptgruppe sowie der Nebengruppen oder auch um andere Seltenerdphosphate handeln. Dem Phosphat können insbesondere auch Zusatzstoffe, wie SiO2, z.B. in Form von Aerosil, pyrogenes Al2O3 oder TiO2 etc. zugesetzt sein. Bevorzugt werden diese Zusatzstoffe als Nanometer-Pulver zugesetzt, insbesondere ist ihre mittlere Partikelgröße im Bereich 1 bis 40 nm angesiedelt. Auch gemahlene Gläser, wie beispielsweise Hartgläser oder gemahlenes Glaslot kann zugesetzt sein. Diese Zusätze können ggf. die Wärmeleitfähigkeit nochmals erhöhen, als Reflektor oder Streumittel dienen, oder auch den thermischen Ausdehnungskoeffizienten anpassen.

Auch ein Zusatz von strahlungsabsorbierenden Komponenten für eine gezielte Erwärmung wie z. B. Vanadiumoxid und/oder von Komponenten mit Filterwirkung wie z.B. wismuthaltige Verbindungen ist möglich. Weitere Komponenten dienen gezielt dazu, den Brechungsindex zu verändern, insbesondere tellurhaltige Verbindungen. Das Metallphosphat ist feuchtebeständig, und wird bevorzugt bei niedrigen Temperaturen hergestellt. Dieses Metallphosphat ist auch zur Einbettung von Leuchtstoffen geeignet, also als Matrix für ein Konversionselement. Der Anteil an Zusatzstoffen kann so hoch sein, dass das Metallphosphat vornehmlich als Bindemittel dient.

Die Anwendung des neuen Klebers führt zu gesteigerter Effizienz und erhöhter Lebensdauer. Dazu wird bevorzugt eine Verklebung oder eine Komponente aus Metallphosphat, ggf. mit Zusatzstoffen die strahlungsabsorbierend oder reflektierend oder Brechungsindex verändernd sind, verwendet. Damit wird eine Erhöhung der UV-Beständigkeit, der thermischen Leitfähigkeit, eine Verbesserung der Temperaturstabilität sowie ggf. ein erhöhter Brechungsindex erzielt.

Ein Teil oder auch alle zugegebenen Komponenten können derart ausgewählt sein, dass sie mit dem Metallphosphat chemisch reagieren und es dadurch modifizieren. Wesentliche Merkmale der Erfindung in Form einer nummerierten Aufzählung sind:
1. Optoelektronisches Halbleiterbauelement mit einer Lichtquelle, einem Gehäuse und elektrischen Anschlüssen, wobei das optoelektronische Halbleiterbauelement ein Konversionselement mit Leuchtstoff und eine Komponente aufweist, die Metallphosphat beinhaltet, dadurch gekennzeichnet, dass das Metallphosphat im wesentlichen alkalifrei und halogenfrei ist, wobei das Metallphosphat höchstens 1 Mol.-% an Alkalioxiden und halogenhaltigen Bestandteilen enthält, wobei die Komponente, die Metallphosphat enthält, entweder eine Matrix für das Konversionselement ist oder dass die Komponente, die Metallphosphat enthält, eine Schutzschicht für Leuchtstoffpartikel ist.
2. Optoelektronisches Halbleiterbauelement nach Anspruch 1, dadurch gekennzeichnet, dass das Metallphosphat 5 bis 75 Mol.-% P2O5 und insbesondere 5 bis 25 Mol.-% Al2O3 oder Y2O3 enthält.
3. Optoelektronisches Halbleiterbauelement nach Anspruch 1, dadurch gekennzeichnet, dass dem Metallphosphat anorganische Komponenten zugesetzt sind, die den Brechungsindex erhöhen und/oder als Füllstoffe dienen und/oder als optischer Filter wirken und/oder reflektieren und/oder entspiegeln und/oder Strahlung absorbieren.

### Kurze Beschreibung der Zeichnungen

Im Folgenden soll die Erfindung anhand von mehreren Ausführungsbeispielen näher erläutert werden. Die Figuren zeigen:
- Figur 1: eine LED mit Glasdeckel im Querschnitt;
- Figur 2: eine LED mit Linse im Querschnitt;
- Figur 3: eine LED mit Konversionselement im Querschnitt;
- Figur 4: ein Halbleiter-Bauelement im Schnitt;
- Figur 5: ein weiteres Ausführungsbeispiel eines Halbleiter-Bauelements im Schnitt.

### Bevorzugte Ausführung der Erfindung

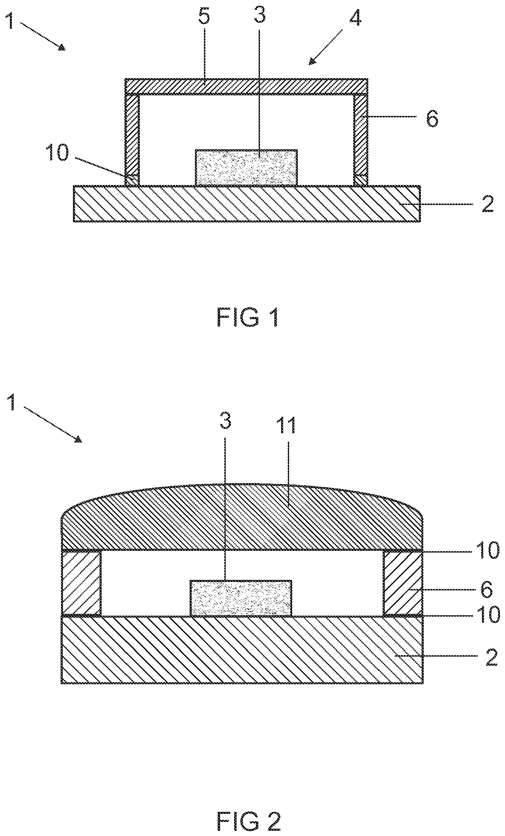

Figur 1 zeigt schematisch eine LED 1 mit einem Board 2. Auf diesem sitzt ein Chip 3. Er ist beabstandet umgeben von einem Glasdeckel 4 mit Deckenwand 5 und Seitenwänden 6. In der Seitenwand sind insbesondere Lüftungsschlitze eingebaut. Die Verbindung zwischen Seitenwand 6 und Board 2 erfolgt über eine Klebespur 10, die aus Metallphosphat gefertigt ist, das bevorzugt alkalifrei und halogenfrei ist.

Figur 2 zeigt schematisch eine LED 1 mit Board 2 und Chip 3. Er ist beabstandet umgeben von einem Glasdeckel. Dieser ist als eine Linse 11 ausgeführt, die aus Metallphosphat gefertigt ist. Sie ist über Seitenwände 6 mit dem Board, welches ebenfalls aus Metallphosphat besteht, verbunden. Zwischen Linse 11 und Seitenwand 6 einerseits und zwischen Seitenwand 6 und Board 2 andererseits wird eine Klebespur 10 aus Metallphosphat verwendet, das höchstens 1 Mol.-% an Oxiden von Alkali- und Halogenelementen enthält. Die Linse 11 selbst ist aus Metallphosphat mit bis zu 1 Mol.-% an Alkalioxiden gefertigt.

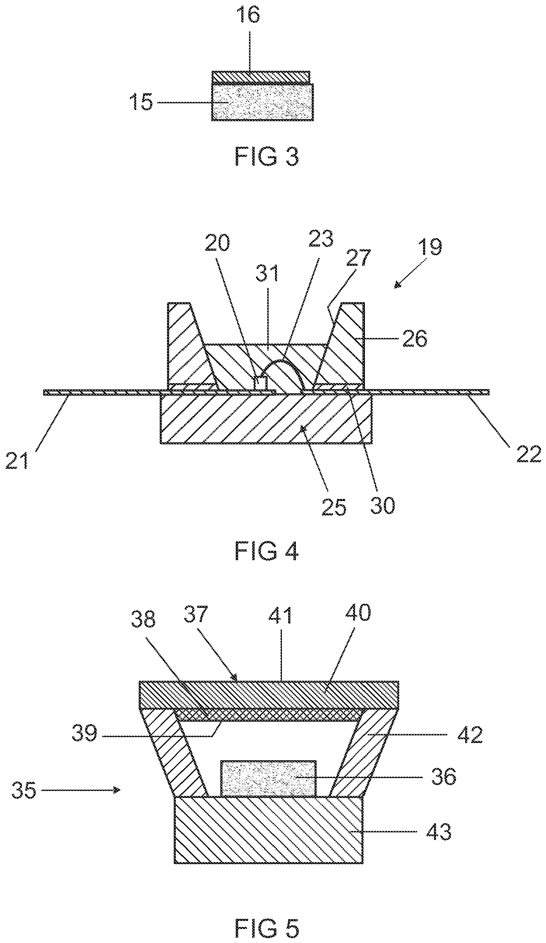

Figur 3 zeigt einen Chip 15 mit Konversionselement 16, das dem Chip 15 direkt vorgelagert ist. Das Konversionselement 16 ist eine dünne Schicht, die als Matrix Metallphosphat verwendet. Darin eingebettet sind ein oder mehrere Leuchtstoffe, wie an sich bekannt. Typische Leuchtstoffe sind YAG:Ce, Sione, Nitride oder auch Orthosilikate oder Calsine. Sie dienen insbesondere dazu, mit Hilfe eines blau oder UV emittierenden Chips weißes Licht zu erzeugen. In einer besonderen Ausgestaltung des Ausführungsbeispiels der Figur 3 sind die Leuchtstoffpartikel durch das Metallphosphat verklebt (Verklebung) oder von diesem umschlossen (Schutzschicht). In letzterem Fall können die so passivierten Leuchtstoffpartikel auch in einer anderen Matrix vorliegen.

Figur 4 zeigt ein optoelektronisches Halbleiter-Bauelement 19 im Schnitt. Kernstück ist ein primär im UV emittierender Chip 20, der mit elektrischen Anschlüssen 21, 22 verbunden ist, die als Leiterrahmenteile ausgebildet sind. Eines der Teile ist über einen Bonddraht 23 mit dem Chip verbunden. Der Chip 20 sitzt direkt auf einem breiten Anschlussteil 21, das auf der Oberfläche 25 eines rechteckigen Grundkörpers aus Glas (Quarz-, Hart-, Weichglas oder Glaslot) oder Keramik angeordnet ist. Auf dem Grundkörper ist ein ringförmiger Aufsatz 26 aufgesetzt, der eine Ausnehmung in seinem Innern frei lässt. Die innere schräge Wand 27 des Aufsatzes ist als Reflektor geformt. Der Aufsatz ist mit dem Grundkörper und dem Leiterrahmen, der von den Anschlüssen gebildet wird, durch einen anorganischen Kleber 30 oder Lotglas verbunden. Der Kleber ist aus alkalifreiem und halogenfreiem Metallphosphat gebildet. Der Aufsatz 26 ist ebenfalls aus Glas gefertigt. Die Ausnehmung innerhalb des Reflektors ist mit einem Gießharz 31 gefüllt, das einen konvertierenden Leuchtstoff einschließt. Statt des Gießharzes kann ein geeignetes Metallphosphat als Matrix verwendet werden. Die LED ist insbesondere mit einer Abdeckscheibe abgeschlossen und somit hermetisch versiegelt.

Insbesondere kann das Konversionselement mit dem Chip über eine Klebung aus Metallphosphat verbunden sein. Das Konversionselement kann aber auch als sog. Dünnschichtelement direkt auf den Chip appliziert sein.

Das Metallphosphat ist alkali- und halogenarm, bevorzugt alkali- und halogenfrei. Das heißt, dass diese Elemente nicht bewusst zugegeben werden und allenfalls von Verunreinigungen der eingesetzten Vormaterialien herrühren. Die Konzentrationen an Alkalimetallen und Halogenen sind deshalb unwesentlich und liegen jeweils unter 1 Mol-%. Dadurch werden ionenbehaftete Komponenten reduziert oder ganz vermieden. Insbesondere gilt dies für ionenbildende Elemente wie Na, Cl, K und F. Diese können nämlich bei Feuchte in die LED gelangen, dadurch die Kontakte angreifen und auch die Ladungsdichten am Chip beeinträchtigen.

Figur 5 zeigt ein optoelektronisches Halbleiter-Bauelement 35 mit zum Chip 36 beabstandeten Konversionselement 37 gemäß dem Remote-Phosphor-Konzept. Der Leuchtstoff 38 ist hier in eine Metallphosphatmatrix 39 eingebettet bzw. von dieser umschlossen. Dieses Element 37 ist auf ein Substrat 40 aufgebracht. Der Leuchtstoff 38 ist vorzugsweise dem Chip 36 zugewandt und das Substrat 40 ist transparent, wie z.B. aus Glas. Vorzugsweise homogenisiert das Konversionselement 37, bestehend aus Konversionsschicht und Substrat, das abgestrahlte Licht. Dazu kann die leuchtstofffreie Seite 41 des Substrats zusätzlich aufgerauht werden. Zusätzlich kann der Leuchtstoff 38 in horizontaler Richtung gezielt inhomogen aufgebracht sein, so dass eine gute Farbhomogenität über alle Winkel gewährleistet und der Leuchtstoff optimal ausgenutzt wird. Die hier beschriebene Remote-phosphor-Lösung ist auch dann anwendbar, wenn die Strahlung mehrerer Chips gemeinsam konvertiert werden soll.

Statt einer LED kann auch eine OLED als optoelektronisches Halbleiterbauelement verwendet werden. Dort sind die obigen Überlegungen mindestens genauso kritisch. Die hermetische Versieglung von OLEDs ist eine der großen Herausforderungen.

Die Herstellung derartiger Metallphosphate gelingt beispielsweise über das bekannte Sol-Gel-Verfahren aus einem löslichen Metallphosphat oder aus dem Reaktionsprodukt von einem Alkoxid mit Phosphorsäure oder aus dem Reaktionsprodukt von Metallsalz oder Metallhydroxid mit Phosphorsäure. Durch eine anschließende Temperaturbehandlung werden Wasser bzw. kohlenstoffhaltige Komponenten abgespalten und das Metallphosphat liegt dann in polymerisierter Form vor. Bevorzugt wird Aluminium-, Yttrium- oder auch eines der eingangs genannten Metallphosphate der anderen Seltenerdphosphate verwendet, weil derartige Phosphate eine hohe Temperatur- und eine gute Feuchtebeständigkeit aufweisen.

Das Metallphosphat kann in amorpher, teilkristalliner oder kristalliner Form vorliegen.

Die Erfindung ist nicht durch die Beschreibung anhand der Ausführungsbeispiele auf diese beschränkt, sondern umfasst jedes neue Merkmal sowie jede Kombination von Merkmalen, die in den Patentansprüchen beinhaltet sind, auch wenn dieses Merkmal oder diese Kombination selbst nicht explizit in den Patentansprüchen oder Ausführungsbeispielen gegeben ist.

Das vorgestellte erfindungsgemäße Metallphosphat kann dienen als:
- anorganischer Kleber zur Befestigung des Konversionselements, z.B. Konverterkeramik und/oder Leuchtstoff in Glas, auf dem Board; in diesem Fall ist das Metallphosphat bevorzugt amorph mit guter Transmission im UV bis hin zum sichtbaren Bereich (VIS).
- anorganischer Kleber zur Befestigung der Linse auf dem Gehäuse;
- anorganischer Kleber zur Befestigung des Glasdeckels auf einem Keramikboard;
- anorganische Matrix eines Konversionselements in die der Leuchtstoff eingebettet ist oder durch die die Leuchtstoffpartikel miteinander verbunden sind, insbesondere direkt auf dem Chip oder als Remote-Phosphor-Konzept; in diesem Fall ist das Metallphosphat bevorzugt amorph mit guter Transmission im UV-VIS;
- anorganische Schutzschicht auf den Leuchtstoffpartikeln, die so passiviert werden und dann auch in eine andere Matrix eingebettet sein können; in diesem Fall ist das Metallphosphat bevorzugt amorph mit guter Transmission im UV-VIS;
- reflektierende Komponente, die z. B. das teurere Titandioxid ganz oder teilweise ersetzt; in diesem Fall ist das Metallphosphat bevorzugt kristallin mit guter Reflektivität im UV-VIS
- Linse; in diesem Fall ist das Metallphosphat bevorzugt amorph mit guter Transmission im UV-VIS
- Board/Gehäuse: Hier ist ein Metallphosphat mit Füllstoff vorteilhaft. Das Metallphosphat kann hier aber auch nur zum Verkleben von keramischen oder glasigen Partikeln eingesetzt werden;
- Abdeckschicht des Konversionselementes, um dieses vor Umwelteinflüssen zu schützen; in diesem Fall ist das Metallphosphat bevorzugt amorph mit guter Transmission im UV-VIS oder teilkristallin und mit zusätzlicher streuender und damit homogenisierender Wirkung. Letzteres kann auch durch Bläschen oder Streupartikel erzielt werden.
- funktionelle Beschichtung wie z. B. Antireflexionsschichten (Entspiegelung), die über dem Konversionselement liegt; hier können zusätzlich Nanopartikel zugegeben oder gezielt eine Nanoporosität eingestellt werden.

Dabei ist anzumerken, dass die verschiedenen Funktionen des Metallphosphats dadurch erreicht werden, dass dessen Zusammensetzung -- beim Beispiel für Aluminiumphosphat ist es im wesentlichen das Al2O3-P2O5-H2O-Verhältnissowie die Vernetzung bei der Temperaturbehandlung an den jeweiligen Einsatzzweck angepasst werden (Transparenz, Trübung, Opazität).

In o.g. Fällen kann das Metallphosphat auch glasige oder keramische Füllstoffe enthalten, die nicht mit aufschmelzen. Der Anteil an Füllstoff oder auch Leuchtstoff kann so hoch sein, dass das Metallphosphat quasi nur als Bindemittel/Klebstoff fungiert, der die Füllstoffpartikel zusammenhält, ähnlich einem keramischen Kleber. Je nach Einsatz und Anforderung können dem Metallphosphat funktionelle Komponenten zugesetzt sein.

Der thermische Ausdehnungskoeffizient des Metallphosphates liegt bevorzugt bei mindestens 5,0 x 10⁻⁶/K.

Das Metallphosphat beinhaltet als Hauptkomponente Phosphat, das in verschiedenen Modifikationen, d. h. als Orthophosphat, Triphosphat, Metaphosphat, Polyphosphat, Ultraphosphat, sowie in allen möglichen Zwischenstufen vorliegen kann.

Im folgenden sollen noch konkrete Ausführungsbeispiele näher erläutert werden.

### Beispiel 1: Anorganischer Kleber zur Befestigung des Konversionselements

Eine wässrige Lösung eines Metallphosphats z. B. Monoaluminiumphosphat Al(H2PO4) x·nH2O (z.B. FFB716 von Budenheim in wässriger Lösung) wird als dünne Schicht auf den Chip aufgetragen und das Konversionselement auf der feuchten Schicht positioniert. Die Aufbringung erfolgt mit den üblichen Beschichtungsverfahren wie zum Beispiel Dip- oder Spin-Coating, Siebdruck, Tampondruck, Aufrakeln, Sprühverfahren usw. Im Anschluss erfolgt die Trocknung bei niedrigen Temperaturen (< 150°C) ggf. zusätzlich bei vermindertem Umgebungsdruck und/oder mit einer Gewichtsbeaufschlagung. Der Einbrand, d.h. die Kondensation liegt im Temperaturbereich von 150-800°C vorzugsweise 200-400°C. Oberhalb 250°C entsteht dann das Triphosphat (AlH2P3O10) und oberhalb 500°C bzw. 600°C langkettige und ringförmige Aluminiumpolyphosphate.

Die max. anzuwendende Einbrenntemperatur ist durch die Temperaturbeständigkeit der Bauteilkomponenten gegeben. Vorzugsweise erfolgt der Einbrand bei Temperaturen von 200-500°C, insbesondere bei 250-350°C.

Optional können der Suspension auch Feststoffe in Pulverform, vorzugsweise Nanopulver wie zum Beispiel pyrogene Kieselsäure (z.B. Aerosil von Evonik) und/oder pyrogenes Al2O3 (z.B. Aeroxid Alu C von Evonik) und/oder pyrogenes TiO2 (z.B. Aeroperl P25 von Evonik) zugesetzt werden, die dann von der Matrix umschlossen werden. Ebenso möglich ist die Zugabe eines gemahlenen Weich-, Hart- oder Quarzglases als auch eines Glaslotes.

Eine weitere Option ist die Zugabe einer wässrigen Lösung eines anderen löslichen Metallsalzes wie zum Beispiel Yttriumacetat oder Yttriumphosphat zu der Suspension. In diesem Fall reagieren die Komponenten miteinander und das Metallphosphat wird dadurch modifiziert.

Zur Befestigung der Linse auf dem Gehäuse und des Glasdeckels auf einem Keramikboard wird ähnlich verfahren. Hier ist zudem möglich, der Suspension strahlungsabsorbierende Komponenten wie z. B. Spinelle, Eisen- oder Vanadiumoxid zu zusetzen, die es ermöglichen, die Klebefläche gezielt mit zum Beispiel IR-Strahlung zu erwärmen.

### Beispiel 2: Anorganische Matrix eines Konversionselements

In einer wässrigen Lösung eines Metallphosphats gemäß Beispiel 1 wird Leuchtstoff zum Beispiel YAG:Ce in Pulverform suspendiert und auf den Chip als Schicht aufgetragen. Im Anschluss erfolgt die Trocknung bei niedrigen Temperaturen (< 150°C) ggf. zusätzlich bei vermindertem Umgebungsdruck. Der Einbrand erfolgt gemäß Beispiel 1.

Der Feststoffgehalt an Leuchtstoff kann je nach gewünschtem Farbort der LED variiert werden. Hierbei ist es auch möglich, Konversionselemente herzustellen, die das vom Chip emittierte Licht zu 100% umwandeln. In diesem Fall ist der Feststoffgehalt an Leuchtstoff so hoch, dass das eingesetzte Metallphosphat die Leuchtstoffpartikel nur mit einer dünnen Schicht umschließt und dadurch miteinander verklebt.

Ferner ist möglich eine Mischung aus verschiedenen Leuchtstoffpulvern (verschiedene Farborte) in das Metallphosphat einzubetten, um verschiedene Lichtfarben (z.B. warmweiß, orange usw.) einzustellen.

Optional können der Suspension gemäß Beispiel 1 auch Feststoffe in Pulverform und/oder Lösungen anderer löslicher Metallsalze zugesetzt werden.

Für den Fall, dass das Konversionselement vom Chip beabstandet sein soll (Remote-Phosphor), wird anstatt des Chips ein transparentes Substrat, z.B. Glas mit einer hohen Transmission im VIS, beschichtet. Vorzugsweise ist die Leuchtstoff beschichtete Seite dem Chip zugewandt.

### Beispiel 3: Anorganische Schutzschicht auf den Leuchtstoffpartikeln

In einer wässrigen Lösung eines Metallphosphats gemäß Beispiel 1 wird Leuchtstoff zum Beispiel YAG:Ce in Pulverform suspendiert und bei niedrigen Temperaturen (< 150°C), ggf. zusätzlich bei vermindertem Umgebungsdruck, getrocknet. Ggf. werden dem Leuchtstoffpulver davor oberflächenaktivierende Substanzen beigegeben, um die Benetzung zu beeinflussen oder um eine Agglomeratbildung zu unterbinden. Im Anschluss wird die feste Masse zerkleinert und pulverisiert. Der Leuchtstoff ist nun von einer dünnen Schutzschicht aus Metallphosphat umgeben. Zur Herstellung des Konversionselementes werden die Leuchtstoffpartikel mit der jetzt umgebenden Schutzschicht aus Metallphosphat in eine andere Matrix wie zum Beispiel Silicon oder Glas eingebettet.

Optional kann das Metallphosphat vorher auch gemäß Beispiel 1 durch Kondensation polymerisiert werden.

Optional können der Suspension gemäß Beispiel 1 auch Feststoffe in Pulverform und/oder Lösungen anderer löslicher Metallsalze zugesetzt werden.

### Beispiel 4: Reflektierende Komponente

Vollständiger oder teilweiser Ersatz der reflektierenden Komponente Titandioxid im LED-Board durch das im Patent DE 10 2007 031 960 A1 beschriebene Aluminiumorthophosphat Dihydrat (Herstellprozess und Anwendung).

### Beispiel 5: Linse

Die wässrige, vorzugsweise konzentrierte Lösung eines Metallphosphats gemäß Beispiel 1 wird in eine Form aus zum Beispiel Metall, Graphit oder Kunststoff oder alternativ auch direkt auf das ggf. vergossene Konversionselement gegossen. In letzterem Fall stellt sich die konvexe Form über den Benetzungswinkel ein. In Anschluss erfolgt die Trocknung bei niedrigen Temperaturen (< 150°C) ggf. zusätzlich bei vermindertem Umgebungsdruck. Der Einbrand erfolgt gemäß Beispiel 1. Die Entformung aus der Gießform kann bereits nach einer mittleren Einbrenntemperatur und dann ohne Form bei höheren Temperaturen erfolgen. Evtl. ist eine Nachbehandlung anzuschließen.

Optional können der Suspension gemäß Beispiel 1 auch Feststoffe in Pulverform und/oder Lösungen anderer löslicher Metallsalze zugesetzt werden.

In einer besonderen Ausgestaltung enthält die Linse auch Leuchtstoffpartikel und wirkt so gleichzeitig als Konversionselement, das u.U. direkt auf den Chip aufgebracht werden kann.

### Beispiel 6: Board/Gehäuse

In einer wässrigen Lösung eines Metallphosphats gemäß Beispiel 1 wird ein oxidischer Füllstoff zum Beispiel Glas, Keramik oder Metalloxid in Pulverform suspendiert und in eine entsprechende Form gegossen. Im Anschluss erfolgt die Trocknung bei niedrigen Temperaturen (< 150°C) ggf. zusätzlich bei vermindertem Umgebungsdruck. Der Einbrand erfolgt gemäß Beispiel 1.

Der Feststoffgehalt an oxidischem Füllstoff kann variiert werden.

In einer besonderen Ausgestaltung ist der Feststoffgehalt an oxidischem Füllstoff so hoch, dass das eingesetzte Metallphosphat die Füllstoffpartikel nur mit einer dünnen Schicht umschließt und dadurch miteinander verklebt.

In einer weiteren besonderen Ausgestaltung ist die Suspension frei von Füllstoffen.

Ferner ist möglich eine Mischung aus verschiedenen oxidischen Füllstoffen in das Metallphosphat einzubetten.

Optional können der Suspension gemäß Beispiel 1 auch Feststoffe in Pulverform und/oder Lösungen anderer löslicher Metallsalze zugesetzt werden.

### Beispiel 7: Abdeckschicht des Konversionselementes

Das Konversionselement wird mit einer wässrigen Lösung eines Metallphosphats gemäß Beispiel 1 dünn beschichtet und bei niedrigen Temperaturen (< 150°C), ggf. zusätzlich bei vermindertem Umgebungsdruck, getrocknet. Der Einbrand erfolgt gemäß Beispiel 1.

Optional kann das Konversionselement auch mit dem Metallphosphat vergossen werden.

Als weitere Option können der Suspension gemäß Beispiel 1 auch Feststoffe in Pulverform und/oder Lösungen anderer löslicher Metallsalze zugesetzt werden.

### Beispiel 8: funktionelle Beschichtung des Konversionselementes

Entsprechend Beispiel 7. Vorzugsweise wird hier so getrocknet und kondensiert, dass in der Schicht feine Bläschen entstehen, die die Brechzahl verringern, wodurch eine Antireflexwirkung erzeugt wird. Alternativ können auch Nanopulver zugesetzt werden.

Bei allen Beispielen können auch Komponenten mit Filterwirkung wie Wismutoxid oder Komponenten die den Brechungsindex verändern, vorzugsweise erhöhen wie Yttriumoxid oder Telluroxid, ebenfalls als lösliche Metallsalze oder als oxidische Partikel zugesetzt werden. Der Ausdehnungskoeffizient wird vorzugsweise durch Partikel wie in Beispiel 1 erwähnt als auch durch Materialien mit negativen Ausdehnungskoeffizienten zum Beispiel β-Eukryptit eingestellt.

Bevorzugt sind die hier vorgestellten Phosphate über eine Art Sol-Gel-Verfahren hergestellt. Generell ist ein Herstellverfahren häufig so gestaltet, dass die Ausgangsstoffe auf über 250 °C erwärmt, kondensiert werden, dann Wasser abgespalten wird, so dass sich lange Ketten bilden. Bei weiterer Erhitzung entstehen beispielsweise monocyclische Ketten.

Konkrete Hinweise finden sich im Detail in DE-A 101 13 287 und in J. Am. Ceram. Soc. Vor. 39/3, S. 89-98 (1956).

Der Begriff Phosphate umfasst hier explizit insbesondere auch Mono-Phosphat wie Al(H2PO4)3 als auch Poly-Phosphat wie [Al(H2PO4)3]n. Je nach Verarbeitung kann dabei MetaPhosphat wie AlP2O7 oder auch tertiäres Phosphat wie Al-PO4 entstehen. Orthophosphate entstehen bei Behandlung mit Temperaturen ab etwa 180 °C, Poly- und Pyro-Phosphate entstehen bei Behandlung mit Temperaturen ab etwa 600 °C. Ein Anhaltspunkt ist ein Verhältnis des Phosphoroxids [P2O5] zum Metalloxid, beispielsweise [Al2O3], von 1:10 als Grenzwert.

## Patentansprüche

1. Optoelektronisches Halbleiterbauelement mit einer Lichtquelle, einem Gehäuse und elektrischen Anschlüssen,
• wobei das optoelektronische Halbleiterbauelement ein Konversionselement mit Leuchtstoff und eine Komponente aufweist, die Metallphosphat beinhaltet,
• **dadurch gekennzeichnet, dass** das Metallphosphat im Wesentlichen alkalifrei und halogenfrei ist, wobei das Metallphosphat höchstens 1 Mol.-% an Alkalioxiden und halogenhaltigen Bestandteilen enthält,
• wobei die Komponente, die Metallphosphat enthält, entweder eine Matrix für das Konversionselement ist oder dass
• die Komponente, die Metallphosphat enthält, eine Schutzschicht für Leuchtstoffpartikel ist.

2. Optoelektronisches Halbleiterbauelement nach Anspruch 1, **dadurch gekennzeichnet, dass** das Metallphosphat 5 bis 75 Mol.-% P2O5 und insbesondere 5 bis 25 Mol.-% Al2O3 oder Y2O3 enthält.

3. Optoelektronisches Halbleiterbauelement nach Anspruch 1, **dadurch gekennzeichnet, dass** dem Metallphosphat anorganische Komponenten zugesetzt sind, die den Brechungsindex erhöhen und/oder als Füllstoffe dienen und/oder als optischer Filter wirken und/oder reflektieren und/oder entspiegeln und/oder Strahlung absorbieren.

## Claims

1. Optoelectronic semiconductor component having a light source, a housing and electrical connections,
• wherein the optoelectronic semiconductor component has a conversion element comprising phosphor and a component that contains metal phosphate,
• **characterized in that** the metal phosphate is substantially free of alkali metal and free of halogen, wherein the metal phosphate contains at most 1 mol% of alkali metal oxides and halogen-containing constituents,
• wherein either the component that contains metal phosphate is a matrix for the conversion element or
• the component that contains metal phosphate is a protective layer for phosphor particles.

2. Optoelectronic semiconductor component according to Claim 1, **characterized in that** the metal phosphate contains 5 to 75 mol% of P2O5 and especially 5 to 25 mol% of Al2O3 or Y203.

3. Optoelectronic semiconductor component according to Claim 1, **characterized in that** inorganic components are added to the metal phosphate which increase the refractive index and/or serve as fillers and/or function as optical filter and/or reflect and/or act as anti-reflection coatings and/or absorb radiation.

## Revendications

1. Composant semi-conducteur optoélectronique comprenant une source de lumière, un boitier et des raccords électriques, le composant semi-conducteur optoélectronique comportant un élément de conversion avec une substance luminescente et un composant qui contient du phosphate métallique, **caractérisé en ce que** le phosphate métallique est sensiblement exempt de composés alcalins et halogénés, le phosphate métallique contenant au maximum 1 % en moles d'oxydes alcalins et composants halogénés,
- dans lequel le composant qui contient du phosphate métallique, est soit une matrice pour l'élément de conversion, soit,
- le composant qui contient du phosphate métallique, est une couche de protection pour des particules de substance luminescente.

2. Composant semi-conducteur optoélectronique selon la revendication 1, **caractérisé en ce que** le phosphate métallique contient 5 à 75 % en moles de P2O5 et en particulier, 5 à 25 % en moles d'Al2O3 ou Y2O3.

3. Composant semi-conducteur optoélectronique selon la revendication 1, **caractérisé en ce que** des composants inorganiques sont ajoutés au phosphate métallique, qui augmentent l'indice de réfraction et/ou servent de matière de remplissage et/ou agissent en tant que filtre optique et/ou réfléchissent et/ou déposent une couche antireflet et/ou absorbent le rayonnement.
